# EUROPÄISCHE PATENTSCHRIFT

(11) **EP 0 757 514 B1**
(45) Veröffentlichungstag und Bekanntmachung des Hinweises auf die Patenterteilung: **28.01.1998**
(21) Anmeldenummer: 96111128.3
(22) Anmeldetag: 11.07.1996
(51) Int. Cl.: H05K 9/00

(54) **Metallgehäuse für den Einbau elektrischer oder elektronischer Bauteile**
Metal housing for electrical or electronic components
Boîte métallique pour composants électriques ou électroniques

(30) Priorität: 02.08.1995 DE 19528313
(43) Veröffentlichungstag der Anmeldung: 05.02.1997
(73) Patentinhaber: BOPLA GEHÄUSE SYSTEME GmbH, D-32257 Bünde (DE)
(72) Erfinder: Ransiek, Holger, 32257 Bünde (DE)
(74) Vertreter: Thielking, Bodo, Dipl.-Ing.

(56) Entgegenhaltungen:
- EP-A- 0 306 694
- EP-A- 0 567 372
- DE-C- 4 311 246
- IBM TECHNICAL DISCLOSURE BULLETIN, Bd. 33, Nr. 6A, 1.November 1990, ARMONK, NY, US, Seiten 213-218, XP000107689 "SELFT-CONTAINED, SELF-SECURED GROUNDING SPRING PROVIDING EMC SHIELDING BETWEEN PLASTIC AND/OR METAL COVERS AND ENCLOSURES"

## Beschreibung

Die Erfindung betrifft ein Metallgehäuse nach dem Oberbegriff des Anspruchs 1.

Bei Gehäusen dieser Art (DE 44 05 408 C1) erfolgt nicht nur eine mechanische Dichtung gegen in den Gehäuseinnenraum eindringenden Staub oder gegen eindringende Feuchtigkeit. Vielmehr müssen derartige Gehäuse häufig auch gegen elektrische und magnetische Störfelder abgeschirmt sein. In solchen Fällen wird eine elektromagnetische Verträglichkeit gefordert. Die Gehäuse, die den entsprechenden Anforderungen genügen, werden kurz als "EMV-Gehäuse" bezeichnet.

Bei derartigen Gehäusen sind unterschiedliche Lösungen für eine möglichst gute Leitfähigkeit im Bereich der Trennfuge zwischen dem ersten und zweiten Gehäuseteil möglich.

Bei einer ersten bekannten Lösung wird eine kontaktierende Schraubverbindung zwischen erstem und zweitem Gehäuseteil geschaffen. Diese Maßnahme reicht jedoch im höheren Frequenzbereich nicht aus, so daß für eine wirksame Abschirmung andere Lösungen vorgesehen sind.

So ist es im Stand der Technik bekannt, leitfähige teure Dichtungen einzusetzen und Nuten und Federn lackfrei zu halten.

Weiterhin ist es auch bekannt (DE-PS 36 12 975), daß der die Nut begrenzende Außenrand des einen Gehäuseteils außen auf dem Rand des gegenüberliegenden Gehäuseteils aufliegt. Damit entsteht außen ein leitender Metall-auf-Metall-Kontakt. Nachteilig an dieser Lösung ist es, daß dieser Bereich nicht vor Korrosion geschützt ist. Es besteht deshalb schon nach kurzer Benutzungsdauer die Gefahr, daß der Kontakt leidet und damit eine ausreichende Abschirmung nicht mehr besteht. Außerdem ist es sehr aufwendig, diesen Bereich lackfrei zu halten, da es in der Regel wünschenswert ist, die äußere Gehäuseoberfläche zu lackieren.

Bei einer weiteren Lösung (DE 44 05 408) der als bekannt vorausgesetzten Art weist der Deckel einen eine umlaufende Nut mit einliegender Dichtung begrenzenden Innenrand und einen Außenrand auf. Bei geschlossenem Deckel greift eine am Gehäuseunterteil vorgesehene umlaufende Feder in die Nut ein und wird gegen die Dichtung gepreßt. Bei dieser bekannten Lösung liegt die Stirnfläche des Innenrandes bei geschlossenem Deckel leitend auf dem Gehäuseunterteil auf, während der Außenrand und das Gehäuseunterteil unter Bildung eines Spaltes kontaktfrei bleiben.

Auch eine solche Lösung hat trotz der Tatsache, daß die Kontaktflächen innerhalb der Dichtung und damit gegen äußere Einflüsse geschützt liegen, verschiedene Nachteile. Bei dem Kontakt handelt es sich um einen reinen Druckkontakt, dessen Qualität einerseits von den Fertigungsgenauigkeiten von Gehäuseoberteil und Gehäuseunterteil abhängt und zusätzlich davon, daß die beiden Gehäuseteile mit Hilfe der Verschlußschrauben ausreichend fest zusammengespannt werden.

Ausgehend von dem zuletzt erwähnten Stand der Technik liegt der Erfindung die Aufgabe zugrunde, ein EMV-Gehäuse so auszubilden, daß ein sicherer Kontakt zwischen den Gehäuseteilen auch bei größeren Fertigungstoleranzen und auch dann gegeben ist, wenn die beiden Gehäuseteile nur mit leichter Vorspannung zusammengezogen sind.

Die Lösung dieser Aufgabe erfolgt mit den Merkmalen des Kennzeichnungsteils von Anspruch 1.

Bevorzugte Ausgestaltungen der Erfindung sind in den Unteransprüchen beschrieben.

Die erfindungsgemäße Lösung schafft durch das Vorsehen sogenannter selbstreinigender Kontakte eine sichere Verbindung zwischen den beiden Gehäuseteilen. Die aus einer Kupfer-Beryllium-Legierung bestehenden Kontaktstreifen sorgen beim Schließen des Gehäuses automatisch für einen einwandfreien elektrischen Kontakt der beiden Gehäuseteile. Die schneidenartigen Kontaktbereiche des Gehäuses zerstören eine insbesondere bei Metallgehäusen aus Aluminiumdruckguß in den meisten Fällen entwickelte Oxydschicht, welche bei allen bekannten EMV-Gehäusen den Übergangswiderstand zwischen den beiden Gehäusehälften stark erhöht.

Nachstehend wird eine bevorzugte Ausführungsform der Erfindung anhand der Zeichnung im einzelnen beschrieben. Es zeigen:

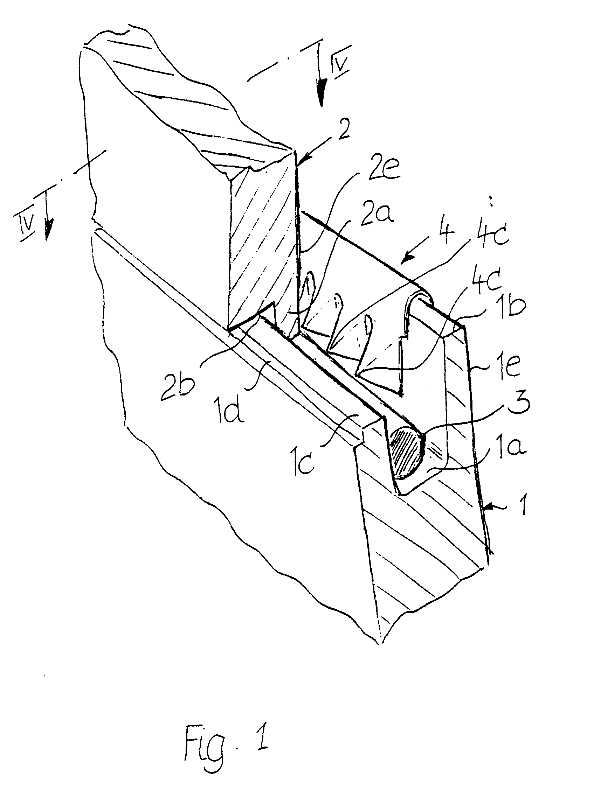

- Figur 1 -: eine perspektivische, teilweise aufgebrochene Darstellung am Übergang zwischen zwei Gehäuseteilbereichen,

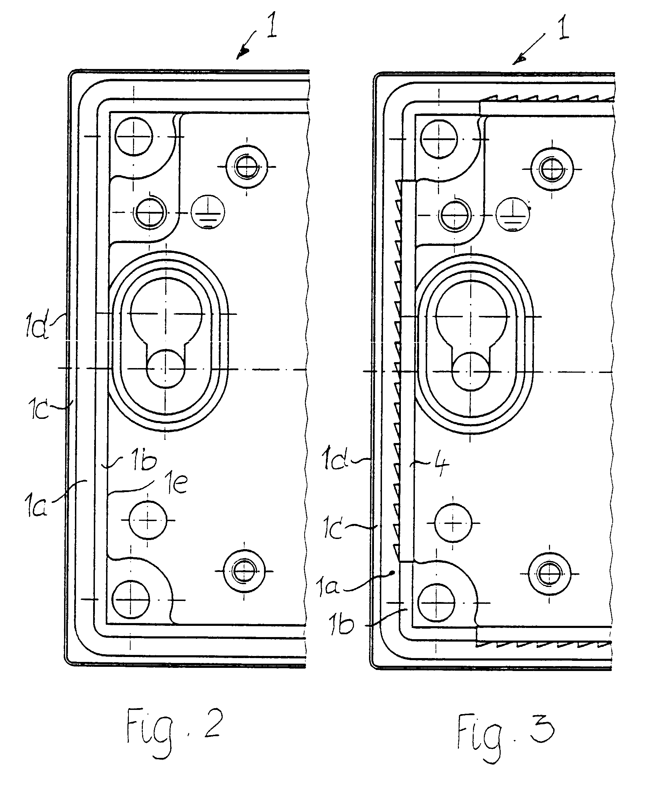

- Figur 2 -: eine Draufsicht auf einen Teilbereich des ersten Gehäuseteils ohne aufgeschobene Kontaktstreifen,

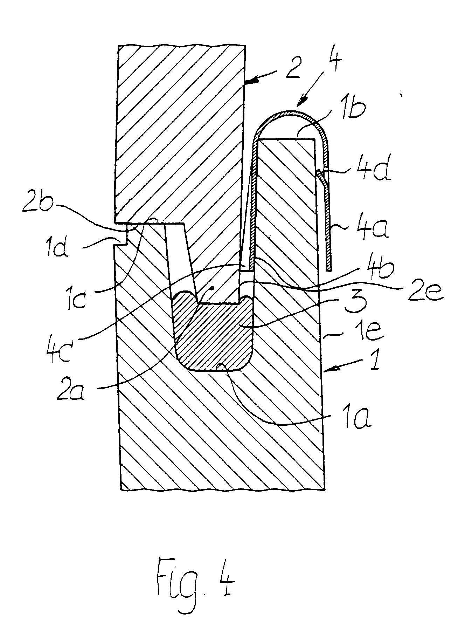

- Figur 3 -: eine der Figur 2 entsprechende Draufsicht mit aufgesteckten Kontaktstreifen,
- Figur 4 -: einen Schnitt entlang Ebene IV-IV gemäß Figur 1.

Das erste Gehäuseteil ist mit 1 bezeichnet und im dargestellten Ausführungsbeispiel ein Gehäuseunterteil. Das zweite Gehäuseteil ist mit 2 bezeichnet und im dargestellten Ausführungsbeispiel ein Gehäuseoberteil.

Das erste Gehäuseteil 1 besitzt eine zwischen seinem Innenrand 1b und seinem Außenrand lc umlaufende Nut 1a. In die Nut 1a ist eine elastische Dichtung 3, beispielsweise eine Rundschnurdichtung eingelegt. Der Innenrand 1b des Gehäuseunterteils ist höher gezogen als der Außenrand 1c. An den Außenrand lc schließt sich ein Absatz 1d an.

Das Gehäuseoberteil 2 besitzt einen in die Nut la eingreifenden Federbereich 2a. An den Federbereich 2a schließt sich ein in Richtung der Trennebene verlaufender äußerer Randbereich 2b an.

Die Innenwand oder innere Seitenwand des zweiten Gehäuseteils 2 ist mit 2e bezeichnet.

Die Innenwand oder innere Seitenwand des ersten Gehäuseteils 1 ist mit le bezeichnet.

Der Innenrand 1b des ersten Gehäuseteils 1 wird von einem etwa U-förmigen Kontaktstreifen 4 übergriffen. Dieser Kontaktstreifen 4 besitzt schneidenartige Kontaktbereiche 4c. Diese schneidenartigen Kontaktbereiche 4c liegen im Schließzustand des Gehäuses an der Innenwand 2e des zweiten Gehäuseteils 2 an. Beim Schließen und Öffnen des Gehäuses erzeugen die schneidenartigen Kontaktbereiche 4c quer zur Trennebene des Gehäuses verlaufende Kontaktbahnen.

Im vollständig geschlossenen Zustand des Gehäuses liegt der äußere Randbereich 2b fest auf dem Außenrand lc des ersten Gehäuseteils 1 auf.

Aus Figur 4 ist ersichtlich, daß der U-förmige Kontaktstreifen 4 mit schneidenartigen Kontaktbereichen 4d an der Innenwand le des ersten Gehäuseteils 1 anliegt. Auf diese Weise ist ein sicherer ständiger Kontakt zwischen dem ersten Gehäuseteil 1 und dem Kontaktstreifen 4 gewährleistet.

Das Verwenden von Kontaktstreifen 4 erzeugt einen sicheren Kontakt ohne nennenswerte Übergangswiderstände zwischen dem ersten Gehäuseteil 1 und dem zweiten Gehäuseteil 2 auch dann, wenn die Ränder 1c und 2b nicht fest aufeinanderliegen, sondern ein Luftspalt zwischen diesen Rändern verblieben ist.

## Patentansprüche

1. Metallgehäuse für den Einbau elektrischer oder elektronischer Bauteile mit zwei zueinander komplementären Gehäuseteilen (1; 2), wobei das erste Gehäuseteil (1) eine zwischen seinem Innenrand (1b) und seinem Außenrand (1c) umlaufende Nut (1a) mit einliegender Dichtung (3) aufweist und das zweite Gehäuseteil (2) einen in die Nut (1a) eingreifenden und zur Auflage auf die Dichtung (3) bestimmten umlaufenden Federbereich (2a) besitzt, an den sich ein äußerer Randbereich (2b) anschließt, der zur Auflage auf den Außenrand (1c) des ersten Gehäuseteils (1) ausgebildet ist,
dadurch gekennzeichnet,
daß der Innenrand (1b) des ersten Gehäuseteils (1) von einem etwa U-förmigen Kontaktstreifen (4) übergriffen wird, der im geschlossenen Zustand des Gehäuses benachbart zum Federbereich (2a) mit schneidenartigen Kontaktbereichen (4c) an dem zweiten Gehäuseteil (2) anliegt, wobei die schneidenartigen Kontaktbereiche (4c) beim Schließen und Öffnen des Gehäuses quer zu dessen Trennebene verlaufende Kontaktbahnen erzeugen.

2. Metallgehäuse nach Anspruch 1,
dadurch gekennzeichnet,
daß der etwa U-förmige Kontaktstreifen (4) mit den schneidenartigen Kontaktbereichen (4c) an der Innenwand (2e) des zweiten Gehäuseteils (2) anliegt.

3. Metallgehäuse nach Anspruch 1 oder 2,
dadurch gekennzeichnet,
daß der etwa U-förmige Kontaktstreifen (4) mit weiteren schneidenartigen Kontaktbereichen (4d) an der Innenwand (1e) des ersten Gehäuseteils (1) anliegt.

4. Metallgehäuse nach einem oder mehreren der Ansprüche 1 bis 3,
dadurch gekennzeichnet,
daß der Kontaktstreifen (4) sich über den größten Teil der Länge mindestens eines Federbereichs (2a) erstreckt.

5. Metallgehäuse nach einem oder mehreren der Ansprüche 1 bis 4,
dadurch gekennzeichnet,
daß an vier Seiten jeweils ein sich über die größte Länge des Federbereichs (2a) erstreckender Kontaktstreifen (4) vorgesehen ist.

6. Metallgehäuse nach einem oder mehreren der Ansprüche 1 bis 5,
dadurch gekennzeichnet,
daß der Innenrand (1b) des ersten Gehäuseteils (1) höher ausgebildet ist als dessen Außenrand (1c).

## Claims

1. Metal housing for building electrical or electronic component parts with two complementary housing parts (1,2) wherein the first housing part (1) has a groove (1a) with insert seal (3) between its inner edge (1b) and outer edge (1c) and the second housing part (2) has a circumferential tongue area (2a) engaging in the groove (1a) and designed to rest on the seal (3), the tongue area being adjoined by an outer edge area (2b) which is formed to rest on the outer edge (1c) of the first housing part (1),
characterised in that the inner edge (1b) of the first housing part (1) is engaged by an approximately U-shaped contact strip (4) which in the closed state of the housing adjoins the second housing part (2) through the adjoining tongue area (2a) and cutter-like contact areas (4c) wherein the cutter like contact areas (4c) during opening and closing of the housing produce contact paths running across the separating plane.

2. Metal housing according to claim 1 characterised in that the approximately U-shaped contact strip (4) adjoins the inner wall (2e) of the second housing part (2) with the cutter-like contact areas (4c).

3. Metal housing according to claim 1 or 2 characterised in that the approximately U-shaped contact strips (4) adjoin the inner wall (1e) of the first housing part (1) with further cutter-like contact areas (4d).

4. Metal housing according to one or more of claims 1 to 3 characterised in that the contact strip (4) extends over the largest part of the length of at least one tongue area (2a).

5. Metal housing according to one or more of claims 1 to 4 characterised in that a contact strip (4) extending over the largest length of the tongue area (2a) is provided on each of the four sides.

6. Metal housing according to one or more of claims 1 to 5 characterised in that the inner edge (1b) of the first housing part (1) is formed higher than its outer edge (1c).

## Revendications

1. Boîte métallique pour le montage d'éléments électriques ou électroniques, laquelle comprend deux parties (1; 2) se complétant mutuellement, la première partie (1) de la boîte présentant une rainure (1a) qui s'étend en continue entre son bord intérieur (1b) et son bord extérieur (1c) et dans laquelle un avec joint d'étanchéité (3) est inséré, tandis que la deuxième partie (2) de la boîte est équipée d'une zone languette (2a) continue qui s'engage dans la rainure (1a) et est destinée à s'appuyer sur le joint, et une zone marginale externe (2b), conçue pour prendre appui sur le bord extérieur (1c) s'appuyer faisant suite à la zone languette (2a),
caractérisée en ce que
le bord intérieur (1b) de la première partie (1) de la boîte est embrassé par une bande de contact (4) approximativement en forme de U, dont les zones de contact (4c) en forme de lames pcrtent, dans le voisinage de la zone languette (2a), contre la deuxième partie (2) de la boîte quand celle-ci est fermée, les zones de contact (4c) générant des voies de contact s'étendant transversalement par rapport au plan de séparation de la boîte lors de la fermeture et de l'ouverture de celle-ci.

2. Boîte métallique selon la revendication 1,
caractérisée en ce que
la bande de contact (4) approximativement en forme de U porte, avec ses zones de contact (4c) genre lames, contre la paroi intérieure (2e) de la deuxième partie (2) de la boîte.

3. Boîte métallique selon la revendication 1 ou 2,
caractérisée en ce que
la bande de contact (4) approximativement en forme de U porte contre la paroi intérieure (1e) de la première partie (1) de la boîte avec d'autres zones de contacts (4d) genre lames.

4. Boîte métallique selon une ou plusieurs revendications 1 à 3,
caractérisée en ce que
la bande de contact (4) s'étend sur la majeure partie de la longueur d'au moins une zone languette (2a).

5. Boîte métallique selon une ou plusieurs revendications 1 à 4,
caractérisée en ce que,
sur quatre côtés, une bande de contact (4) s'étendant sur la majeure partie de la zone languette (2a) est respectivement prévue.

6. Boîte métalliquea selon une ou plusieurs revendications 1 à 5,
caractérisée en ce que
le bord intérieur (1b) de la première partie (1) de la boîte est plus haut que le bord extérieur (1c)de celle-ci.
